# EUROPEAN PATENT SPECIFICATION

(11) **EP 3 117 437 B1**
(45) Date of publication and mention of the grant of the patent: **23.10.2019**
(21) Application number: 15708171.2
(22) Date of filing: 02.03.2015
(51) Int. Cl.: G11C 13/04, G11C 15/04, G11C 7/10, G11C 7/00

(54) **OPTICALLY TRANSMISSIVE INFORMATION STORAGE UNIT**
OPTISCH DURCHLÄSSIGE INFORMATIONSSPEICHEREINHEIT
UNITÉ DE MÉMOIRE D'INFORMATIONS OPTIQUEMENT TRANSMISSIVE

(30) Priority: 13.03.2014 EP 14159331
(43) Date of publication of application: 18.01.2017
(73) Proprietor: Signify Holding B.V., 5656 AE Eindhoven (NL)
(72) Inventor: GUILLANNEUF, Frederic Alexandre, NL-5656 AE Eindhoven (NL); KRIJN, Marcellinus Petrus Carolus Michael, NL-5656 AE Eindhoven (NL)
(74) Representative: Verweij, Petronella Daniëlle
(86) International application number: PCT/EP2015/054227
(87) International publication number: WO 2015/135770

(56) References cited:
- EP-A2- 0 635 841
- US-A- 3 130 305
- ZWIEG ET AL: "Optical Content Addressable Retrieval System", IP.COM JOURNAL, IP.COM INC., WEST HENRIETTA, NY, US, 1 March 1965 (1965-03-01), XP013083391, ISSN: 1533-0001

## Description

### FIELD OF THE INVENTION

The present invention relates to a storage device and to a method of controlling a storage device.

### BACKGROUND OF THE INVENTION

The computational power in modern computers has increased dramatically in the past decades. In modern electronic devices, a large number of electronic components are electrically connected for communicating with each other. In some applications, discrete components are mounted on a printed circuit board (PCB) which comprises the required conductive paths for interconnecting the components. For more complex applications where a larger number of components are required, integrated circuits are used where components are made in a semiconductor substrate and where communication between components takes place in different metal layers arranged on the substrate.

With increasing complexity of both integrated circuits as well as of circuits comprising discrete components arranged on a PCB follows problems related to the communication between components. In an integrated circuit comprising millions of components, more and more conductive layers need to be used to achieve the required communication paths between different components. The addition of metal layers in integrated circuits leads both to a more complex manufacturing process and to problems associated with heat dissipation from components. Similarly, with an increasing number of discrete components on a PCB, the connection paths become more complex while the area of the PCB may be limited, which may in turn lead to limitations in functionality of the circuit.

Furthermore, the demands on the performance, such as processing speed and power consumption, of electronic devices developed today are increasing and at the same time it is more and more important to reduce the size of the circuit for use in various portable devices. To keep up with the higher demands, the number of components in electronic devices therefore increases, which means the number of possible and required connections and contacts in the device grows rapidly and thus also the overall complexity of the circuit.

A limitation in modern computers is the speed of retrieval of information from a storage device of the computer. With the increasing complexity of the components, such as the storage device, the communication between the storage device and the processor of the computer becomes increasingly complicated, thus limiting the speed of retrieval of information from the storage device. For efficient retrieval of information in a storage device it is desirable to access different locations in the storage device in parallel. However, parallel access is difficult in for example high capacity storage devices because of e.g. limited bus width.

In US6118682 a method for reading multiple addresses in a storage device is disclosed. The method disclosed in US6118682 is based on efficient matching of entries in the storage device. However, the method disclosed in US6118682 relies on a complicated circuitry and communication paths of a circuit comprising and communicating with the storage device. There is thus a demand for an improved method and device for retrieval of information from a storage device.

US 3,130,305 further discloses an optical system for retrieving stored information. EP 0 635 841 A2 discloses opto-electronic memory systems. Non patent literature document from ZWIEG ET AL, IP.COM JOURNAL, IP.COM INC., WEST HENRIETTA, NY, US, 1 March 1965 (1965-03-01), XP013083391, ISSN: 1533-0001 discloses an optical content addressable retrieval system.

### SUMMARY OF THE INVENTION

In view of the above-mentioned and other drawbacks of the prior art, a general object of the present invention is to provide an information storage unit according to independent claim 1, a storage system according to independent claim 11 and a method of retrieving information data from a storage device according to independent claim 13. Preferred aspects are defined in dependent claims 2-10, 12, 14.

According to a first aspect of the invention there is provided an information storage unit according to independent claim 1.

An optically transmissive component is a component that allows for at least a portion of an optical signal to pass through a material of the component such that information of the optical signal may accurately be received by the light-receiving device. Optically transmissive may be e.g. transparent, semi-transparent, translucent, or combinations thereof.

The present invention is based on the realization that by using components made from optically transmissive materials, a light-receiving device arranged in the information storage unit receives optical signals from several directions. With such an information storage unit, communication is enabled through optical signals which will not be obstructed by the optically transmissive components of the information storage unit. The invention further enables parallel and simultaneous access to all information storage units of a storage device. Thus, by addressing all units in parallel, a time of retrieval of information from such a storage device is reduced, thereby; the speed of the device is increased. Moreover, the retrieval of information via optical signals does not depend on bus width which further increases the speed of the device. Furthermore, sending information via optical signals enables communication independent of the complexity of the circuit layout if the information storage units are optically transmissive since the optical signal travels through the optically transmissive units. In other words, an optical signal is received omnidirectionally by a light-receiving device arranged in an information storage unit. Being able to receive signals from all directions enables flexibility in designing a storage device comprising the information storage unit because the location of the information storage units in the storage device is independent of each other. Thus, a relevance of a particular layout of the circuit is almost eliminated.

In one embodiment of the present invention, the information storage unit may further comprise an optically transmissive light-emitting device electrically connected to the optically transmissive control unit. By arranging an optically transmissive light-emitting device in the information storage unit, communication from the information storage unit is enabled via optical signals. The light-emitting device may be arranged such that it may emit optical signals in all directions (i.e. omnidirectionally). Hence, the light-emitting device enables parallel and simultaneous communication via optical signals from the information storage unit with e.g. several other information storage units.

In one embodiment of the present invention, the control unit may further be configured to, if the information data corresponding to the request is found on the memory element, control the optically transmissive light-emitting device to emit a second optical signal indicative of the requested information data. Using optical signals to communicate from the information storage unit further reduces the need for electrical connections for communication. Thus, by enabling communicating from the information storage unit with optical signals increases the flexibility of designing a storage device comprising information storage units. The information data may be storage content or a storage location. For example, a request may be if certain information is stored on the specific information storage unit, thus, the signal indicative of the requested information data may be a storage location. The request may further be for a content stored in an information storage unit. In such case the signal indicative of the requested information data comprises information data in the form of content. A content stored on the information storage unit may for example be a specific data file, e.g. a text-file, an executable file, a picture file, or any other content suitable for storing on a storage device.

In one embodiment of the present invention, the information storage unit may further comprise electrically conductive paths arranged to electrically connect the optically transmissive control unit to an external control unit arranged at a distance from the information storage unit, and configured to transmit a signal indicative of the requested information data to the external control unit. Electrical conductive paths may enable using conventional electrical connections for the retrieval of information from the information storage unit. Furthermore, the electrical conductive paths may be optically transmissive by manufacturing them from an appropriate material. For example, the electrical conductive paths may be made from ITO (Indium Tin Oxide). With the electrically conductive paths, an information storage unit may further be directly addressed using electrical signals. Furthermore, the electrical conductive paths for sending electrical signals may be combined with light-emitting devices for sending optical signals.

According to one embodiment of the invention, the information storage unit may further comprise electrically conductive paths arranged to provide electrical power to the information storage unit. For example, the electrical conductive paths may be made from ITO (Indium Tin Oxide) which enables optically transmissive electrical conductive paths for providing power to the information storage unit.

According to one embodiment, the information storage unit may further comprise a radio-frequency receiver unit configured to wirelessly receive power from a remote transmitter and to provide electrical power to the information storage unit. Using wireless power further reduces the need for electrical connections.

According to one embodiment of the invention there is provided a storage device comprising a plurality of information storage units, wherein the information storage units may be arranged such that an optical signal may propagate unguided from the external light-emitting device to any of the information storage units. The plurality of information storage devices may be stacked in several dimensions, thus forming a network or matrix of information storage units. Furthermore, the information storage units may be arranged such that each information storage unit is in contact with at least one other information storage unit. A plurality of information storage units may thus be arranged such that the optical signal propagates unguided from a light-emitting device to a light-receiving device through one or more information storage units. For example, an optical signal may pass through an optically transmissive light-receiving device which enables further layout possibilities of information storage devices. In other words, the optical signals are not guided from a first information storage unit to a second information storage unit but are emitted by the light-emitting device and may propagate freely through both optically transmissive solid materials and air. Thus, the optical signals may reach at least two of the information storage units in parallel, enabling sending a request for information to several information storage units of the storage device in parallel and essentially simultaneously. Communication via unguided optical signals further eliminates the need for guiding the optical signal through e.g. an optical fiber or using mirrors, thus the complexity of the storage device is reduced. By reducing the need for physical connections between components the number of connections may be increased and thus the processing speed of the storage device may be increased with reduced complexity with respect to the number of interconnects. In this way, it allows for communication between a plurality of information storage units which are all optically transmissive, and arranged anywhere among a plurality of information storage units. Furthermore, the invention enables flexibility in designing an information storage device which is independent of the locations of the information storage units within the information storage device. Thus, a number of electrical connections between information storage units of the information storage device made via physical connections such as wires may be reduced. Furthermore, the optical signal may reach each of the information storage units which means a request for information may be sent to each information storage unit of the storage device in parallel. Thus, a request for information stored in different information storage units may reach all of the information storage units simultaneously. Furthermore, sending a request for information in parallel to all information storage units of the storage device may increase the speed of retrieval of information from the storage device.

According to one embodiment not falling under the scope of protection of the appended claims, the external light-emitting device may be arranged in a processing unit of a computer. For example, the light-emitting device may thus emit a signal comprising a request for information data from the processing unit to the storage device. In one example, the light-emitting device, the processing unit and the storage device are arranged in a computer. Furthermore, the external light-emitting device and the processing unit may for example be arranged in a second storage device such that an optical signal comprising a request or a signal indicative of the requested information data may be transmitted between the storage devices for exchange of information. Thus, a large network of storage devices exchanging information via optical signals may be obtained. Furthermore, the storage devices may exchange information directly between individual storage units of the respective storage devices. In one embodiment the requesting unit is a control unit, such as a processor, of a computer.

In one embodiment of the invention, a plurality of information storage units may be arranged such that an optical signal may propagate unguided from the first information storage unit to a second information storage unit through a third information storage unit. Thus, the optical signal is not obstructed by an information storage unit arranged in the path of the optical signal. In this way, communication between several information storage units within a storage device via unguided optical signals is facilitated. For example, it may be desirable for the individual information storage units to communicate with each other for sharing information regarding e.g. information data stored on the respective memory element.

According to one embodiment of the invention, each of the information storage units is arranged adjacent to and in contact with at least one other information storage unit. For example, the information storage units may be closely packed in an array.

According to one embodiment of the invention, each of the information storage units is provided in the form of a cuboid, and arranged adjacent to and in contact with at least three other information storage units. Thus, the information storage units may be closely packed still enabling communication via optical signals. The information storage units may for example be arranged in a three dimensional array structure.

According to one embodiment not falling under the scope of protection of the appended claims, the light-receiving device may advantageously be a solid state phototransistor or photodiode. The light-emitting device may advantageously be a solid state lighting device, in which light is generated through recombination of electrons and holes. Such light-emitting device may advantageously be a light-emitting diode. The optically transmissive light-receiving device is advantageously made from indium-gallium-zinc-oxide. However, the optically transmissive light-receiving device may be made from any other suitable material. In one embodiment of the invention the control unit may comprise an oxide thin film transistor.

According to a second aspect of the invention, there is provided a storage system comprising a plurality of information storage units according to independent claim 11.

According to an embodiment, the storage system may further comprise a light-receiving device connected to the processing unit for receiving optical signals from any of the information storage units.

Effects and features of this second aspect of the present invention are largely analogous to those described above in connection with the first aspects of the invention and embodiments mentioned are largely compatible with embodiments mentioned in connection with the second aspect of the invention.

According to a third aspect of the invention there is provided a method of retrieving information data from a storage device according to independent claim 13.

Each of the information storage units which receive the request performs a retrieval of information data stored on the memory element of the corresponding information storage unit. The information storage units which find information data corresponding to the request, transmit a signal comprising an indication of the requested information data.

According to an embodiment of the invention, if the requested information data is located in more than one of the plurality of information storage units, performing multiplexed transmission of signals indicative of the requested information data more than one information storage units. Multiplexing may be time multiplexing of frequency multiplexing. Time multiplexing of signals has the meaning of sending information data via signals from the information storage units subsequently from each of the information storage units. Thus, signals are sent as a train of signals. In frequency multiplexing, the signals may be transmitted at different wavelengths for separating and identifying individual optical signals sent from each of the information storage units. Thus, when using frequency multiplexing, signals may be transmitted simultaneously but at different wavelengths.

Effects and features of this third aspect of the present invention are largely analogous to those described above in connection with the first and second aspects of the invention and embodiments mentioned are largely compatible with embodiments mentioned in connection with the first and second aspects of the invention.

Further features of, and advantages with, the present invention will become apparent when studying the appended claims and the following description. The skilled person realize that different features of the present invention may be combined to create embodiments other than those described in the following, without departing from the scope of the present invention.

The scope of protection of the present invention is defined by appended claims 1-14.

### BRIEF DESCRIPTION OF THE DRAWINGS

These and other aspects of the present invention will now be described in more detail, with reference to the appended drawings showing exemplary embodiments of the invention, wherein:
Fig. 1 schematically illustrates an information storage unit according to an embodiment of the invention;
Fig. 2 illustrates an information storage unit according to an embodiment of the invention;
Fig. 3 illustrates a plurality of information storage units forming a storage device according to an embodiment of the invention;
Fig. 4 illustrates an exploded view of a storage device according to an embodiment of the invention; and
Fig. 5 illustrates a flow-chart outlining the general steps of a method according to an embodiment of the invention.

### DESCRIPTION OF EXAMPLE EMBODIMENTS OF THE PRESENT INVENTION

In the following description, the present invention is mainly described with reference to a storage device comprising information storage units arranged in a computer. It should, however, be noted that this by no means limits the scope of the invention, which is equally applicable to other applications, such as, coded light luminaires, mobile phones, watches, heads-up displays, television sets, displays, and games, or other applications where storage devices are applicable.

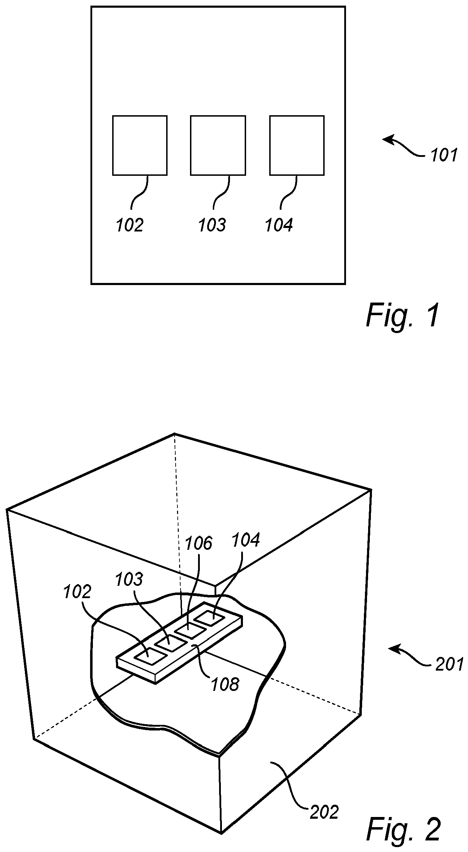

Fig. 1 schematically illustrates an information storage unit 101 in accordance with the invention. Fig. 1 schematically shows a light-receiving device 102, a control unit 103, and a memory element 104. The light-receiving device 102 is configured to receive an optical signal comprising a request for retrieving information data stored in the memory element 104. The control unit 103 is connected to the light-receiving device 102 and to the memory element 104 such that the control unit may retrieve information data stored in the memory element 104 based on the request received by the light-receiving device 102. Furthermore, the light-receiving device 102, the control unit 103, and the memory element 104 are optically transmissive. In some examples, the light-receiving device 102 may be a photo-diode. Furthermore, in one example the control unit 103 is further configured to write information to the memory element 104.

Fig. 2 illustrates a possible layout of an exemplary information storage unit 201. The information storage unit 201 comprises the optically transmissive light-receiving device 102, an optically transmissive light-emitting device 106, the optically transmissive control unit 103, and the optically transmissive memory element 104, optionally housed in and an optically transmissive housing 202. The optically transmissive housing 202 and the optically transmissive components 102-106 enable an optical signal to be received by the light-receiving device 102 from all directions. The light-receiving device 102 may receive an optical signal which may comprise a request for retrieving information data stored on the memory element 104. In one exemplary embodiment, the control unit 103 may control a light-emitting device 106 to emit an optical signal which comprising the requested information data or an indication of whether the information data was found on the memory element 104. The optically transmissive housing 202 and the optically transmissive components 102-106 enable an optical signal to be transmitted from the light-emitting device 106 in all directions. In another exemplary embodiment, there may be electrical connections for transmitting of information data from the information storage unit 201, or, electrical connections may complement the optical communication achieved with the light-emitting device 106, thus a combination is possible. The information storage unit 201 may further comprise optically transmissive electrical lines for providing power to the information storage unit 201. The optically transmissive electrical lines may be made from ITO (Indium-Tin-Oxide). Furthermore, the information storage unit 201 may in principle have any shape, such as ellipsoidal, cubic, or a freeform shape. In the exemplary information storage unit depicted in Fig. 2, the light-receiving device 102, the light-emitting device 106, the control unit 103, and the optically transmissive memory element 104 are arranged on an optically transmissive circuit board 108.

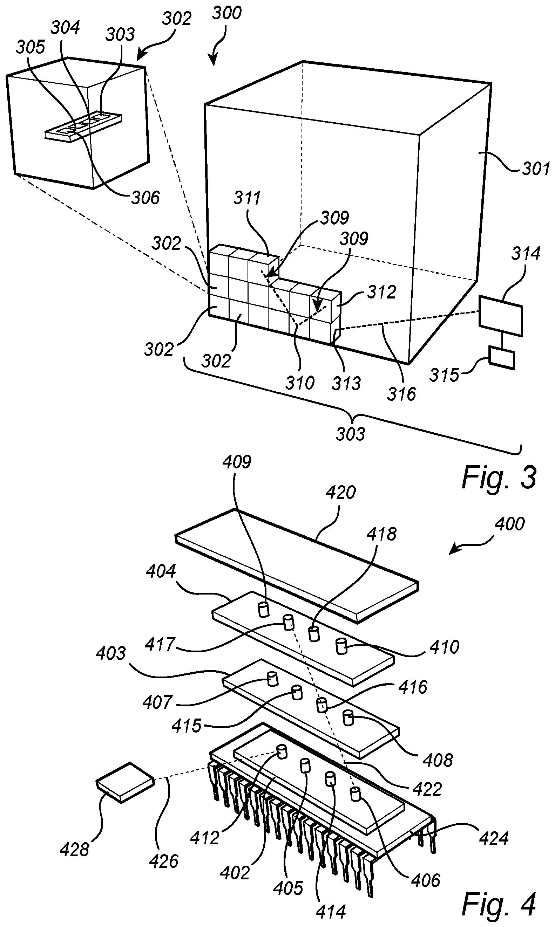

Fig. 3 illustrates an embodiment of a storage system 303 according to an embodiment of the invention. Fig. 3 shows a plurality of information storage units 302 (only some are numbered in order to avoid cluttering in the drawing) each comprising an optically transmissive light-emitting device 303, an optically transmissive light-receiving device 304, an optically transmissive control unit 305, and an optically transmissive memory element 306. Furthermore, there is a light-emitting device 314 arranged external to the information storage units 302. The light-emitting device 314 is connected to a processing unit 315 arranged in e.g. a computer. The light-emitting device 314 may emit an optical signal 316 comprising a request for information data that is received by at least one optically transmissive light-receiving device, for example a light-receiving device arranged in e.g. the optically transmissive information storage unit 313. The optical signal 316 may propagate unguided from the external light-emitting device 314 to the optically transmissive information storage unit 313, or any of the other optically transmissive information storage unit 302, or to all of the information storage units 302.

Additionally, Fig. 3 illustrates an embodiment of a storage device 300 according to an embodiment of the invention. The storage device 300 comprises a plurality of information storage units 302. Each of the information storage units 302 (only some are numbered in order to avoid cluttering in the drawing) comprises an optically transmissive light-emitting device 303, an optically transmissive light-receiving device 304, an optically transmissive control unit 305, and an optically transmissive memory element 306. The optically transmissive information storage units 302 are arranged in an optically transmissive housing 301 such that an optical signal may propagate unguided from an external light-emitting device 314 to a light-receiving device arranged in an information storage unit 302. For example, as shown in Fig. 3, an optical signal 316 emitted by the external light-emitting device 314 is received by a light-receiving device arranged in information storage unit 313. Furthermore, an optical signal may be emitted from an information storage unit and received by a remote information storage unit. For example, as shown in Fig. 3, an optical signal 309 emitted by a light-emitting device arranged in information storage unit 310 is received by a light-receiving device arranged in a remote information storage unit 311. The optical signal is emitted in all directions, the optical signal may therefore also reach other light-receiving devices arranged in other information storage unit, for example a light-receiving device arranged in a remote information storage unit 312. Hence, the information storage units 302 are arranged such that an optical signal, comprising a request for information data, may propagate unguided from a light-emitting device to any, or all, of the information storage units 302. Furthermore, the control unit 305 may control the light-emitting device of an information storage unit 302 which received a request for information data to emit an optical signal which may comprise the requested information data or an indication of whether the information data was found on the memory element 302. Furthermore, the information storage units 302 may comprise means for receiving power wirelessly, for example a radio-frequency receiver for directly providing power to the light-emitting device 303, the light-receiving device 304, the control unit 305, and the memory element 306, or for charging the an energy storage device such as a rechargeable battery connected to an information storage unit. With the means for providing power wirelessly, the information storage units 302 may be arranged randomly in the optically transmissive housing 301 without still enabling an optical signal emitted from e.g. light-emitting device 314 to be received by a light-receiving device arranged in any of the information storage units 302.

Fig. 4 illustrates an exemplary embodiment of a storage device 400 according to the invention in the form of an integrated circuit 400. The integrated circuit comprises several layers 402-404 of optically transmissive material, each layer comprising respective information storage units 405-418. A casing 420 encloses the integrated circuit 400. Communication within the integrated circuit 400 is enabled by transmission of an optical signal 422 from, for example, the information storage unit 406 in layer 402 to the light-information storage unit 417 in layer 404. In Fig. 4, the optical signal 422 emitted by the light-emitting device of information storage unit 406 propagates unguided through the optically transmissive layer 403, and the optically transmissive information storage unit 416 to be received by the light-receiving device of information storage unit 417 arranged in layer 404. In some examples, the casing 420 and a substrate 424 are optically transmissive which enables optical signals 426 emitted by an external light-emitting device 428 to be received by a light-receiving device of e.g. information storage unit 412 (or any of the other information storage units 405-418) of the integrated circuit 400. The optical signals 426, 422 may comprise a request for retrieving information data stored on a memory element. Furthermore, the control unit of an information storage unit may control the corresponding light-emitting device to emit an optical signal comprising the requested information data or an indication of whether the information data was found on the corresponding memory element. For example, the optical signal 422 may be a signal indicative of requested information data, if the information data was found on the memory element of information storage unit 406.

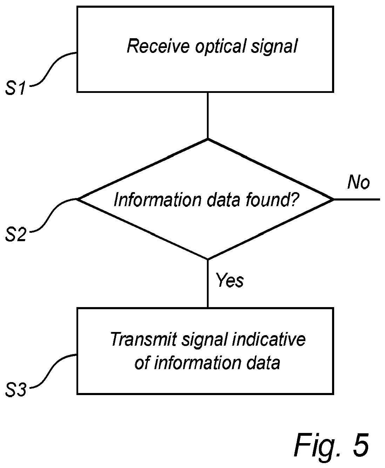

Fig. 5 is a flow chart illustrating the general steps of a method according to an embodiment of the invention. In a first step S1, each of the information storage units 302 receives an optical signal comprising a request for retrieving information data stored on the respective memory element. Thus, each of the information storage units receives the request for the information data essentially simultaneously. Therefore, a search for the information data in each of the memory elements may be performed in parallel, essentially simultaneously. If the information data is found S2, in a subsequent step S3, a response to the request may be transmitted from the information storage units, either through optical signals or through electrical signals. A response is transmitted from the information storage units which have found information data in the respective memory element corresponding to the request. The response may be multiplexed in time, emitted at different wavelengths, or be relayed by electronic non-light-emitting units.

Additionally, variations to the disclosed embodiments can be understood and effected by the skilled person in practicing the claimed invention, from a study of the drawings, the disclosure, and the appended claims. The invention is applicable to various applications such as e.g. intelligent coded light luminaires, or for high-capacity parallel computing applications. The optical signals emitted or transmitted may be coded optical signals, in other words, a control unit of the invention is able to read and/or decode the coded optical signal. In accordance with the invention, a control unit of an information storage unit may also write information to the memory element of the information unit.

In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. An information storage unit (101, 201, 302) comprising:
an optically transmissive memory element (104, 306);
an optically transmissive light-receiving device (102, 304) configured to receive an optical signal, at least a portion of said optical signal to pass through a material of said optically transmissive light-receiving device (102,304), from several directions, said optical signal communicating with the memory element (104, 306) and comprising a request for retrieving information data stored in said memory element (104, 306); and
an optically transmissive control unit (103, 305) electrically connected to said light-receiving device (102, 304) and to said memory element (104, 306), wherein said control unit (103, 305) is configured to communicate with the memory element (104, 306) to retrieve information data stored in said memory element (104, 306) based on said request;
wherein said information storage unit (101, 201, 302) is arranged and configured such that an optical signal transmitted from a light-emitting device external to said information storage unit (101, 201, 302) propagates unguided from said external light-emitting device to said light-receiving device (102, 304) through said information storage unit.

2. The information storage unit (101, 201, 302) according to claim 1, further comprising an optically transmissive light-emitting device (106, 303) arranged for emitting light in several directions and electrically connected to said optically transmissive control unit (103, 305).

3. The information storage unit (101, 201, 302) according to claim 2, wherein said control unit (103, 305) is further configured to, if said information data corresponding to said request is found on said memory element (104, 306), control said optically transmissive light-emitting device (106, 303) to emit an optical signal indicative of said requested information data.

4. The information storage unit (101, 201, 302) according to claim 1, further comprising electrically conductive paths arranged to electrically connect said optically transmissive control unit (103, 305) to an external control unit arranged at a distance from said information storage unit (101, 201, 302), and configured to transmit a signal indicative of said requested information data to said external control unit.

5. The information storage unit (101, 201, 302) according to claim 1, further comprising electrically conductive paths arranged to provide electrical power to said information storage unit (101, 201, 302).

6. The information storage unit (101, 201, 302) according to claim 1, further comprising a radio-frequency receiver unit configured to wirelessly receive power from a remote transmitter and to provide electrical power to said information storage unit (101, 201, 302).

7. A storage device (300, 400) comprising a plurality of information storage units (101, 201, 302) according to any of claims 1 to 6, wherein said information storage units (101, 201, 302) are arranged such that an optical signal propagates unguided from said external light-emitting device to any of said information storage units (101, 201, 302).

8. The storage device (300, 400) according to claim 7, wherein said plurality of information storage units (101, 201, 302) are arranged such that an optical signal propagates unguided from a first information storage unit (101, 201, 302) to a second information storage unit (101, 201, 302) through a third information storage unit (101, 201, 302).

9. The storage device (300, 400) according to claim 7, wherein each of said information storage units (101, 201, 302) is arranged adjacent to and in contact with at least one other information storage unit (101, 201, 302).

10. The storage device (300, 400) according to claim 7, wherein each of said information storage units (101, 201, 302) is provided in the form of a cuboid, and arranged adjacent to and in contact with at least three other information storage units (101, 201, 302).

11. A storage system (303) comprising a plurality of information storage units (101, 201, 302) and a processing unit (315), each of said plurality of information storage units (101, 201, 302) comprising:
an optically transmissive memory element (104, 306);
an optically transmissive light-receiving device (102, 304) configured to receive an optical signal, at least a portion of said optical signal to pass through a material of said optically transmissive light-receiving device (102,304), from several directions, said optical signal communicating with the memory element (104, 306) and comprising a request for retrieving information data stored in said memory element (104, 306); and
an optically transmissive control unit (103, 305) electrically connected to said light-receiving device (102, 304) and to said memory element (104, 306), wherein said control unit (103, 305) is configured to communicate with the memory element (104, 306) to retrieve information data stored in said memory element (104, 306) based on said request;
wherein each of said information storage units (101, 201, 302) is arranged and configured such that an optical signal transmitted from a light-emitting device external to at least one of said plurality of information storage units (101, 201, 302) propagates unguided from said external light-emitting device to said light-receiving device (102, 304) through one or more information storage units,
wherein said external light-emitting device is connected to said processing unit.

12. The storage system (303) according to claim 11, further comprising a light-receiving device connected to said processing unit for receiving optical signals from any of said information storage units (101, 201, 302) comprising an optically transmissive light-emitting device (106, 303) arranged for emitting light in several directions and electrically connected to said optically transmissive control unit (103, 305).

13. A method of retrieving information data from a storage device (300, 400), comprising:
a plurality of information storage units (101, 201, 302) according to claim 1;
said method comprising the steps of:
receiving (S1), by each of said plurality of information storage units (101, 201, 302), an optical signal comprising a request for retrieving information data from said memory element (104, 306); each of the information storage units receiving the request for the information data simultaneously
determining (S2) whether said requested information data is located in any of said information storage units (101, 201, 302); and
if said requested information data is located in an information storage unit (101, 201, 302), controlling (S3), a light-emitting device (106, 303) arranged in said information storage unit (101, 201, 302) where said requested information data is located to transmit an optical signal comprising information indicative of said information data.

14. The method according to claim 13, wherein if said requested information data is located in more than one of said plurality of information storage units (101, 201, 302), performing multiplexed transmission of signals indicative of said requested information data from more than one information storage units (101, 201, 302).

## Patentansprüche

1. Informationsspeichereinheit (101, 201, 302), umfassend:
ein optisch durchlässiges Datenspeicherelement (104, 306);
eine optisch durchlässige Lichtempfangsvorrichtung (102, 304), die konfiguriert ist, ein optisches Signal zu empfangen, wobei mindestens ein Teil des optischen Signals von einigen Richtungen durch ein Material der optisch durchlässigen Lichtempfangsvorrichtung (102, 304) geht, wobei das optische Signal mit dem Datenspeicherelement (104, 306) kommuniziert, und eine Anfrage umfasst, um Informationsdaten zu beziehen, die im Datenspeicherelement (104, 306) gespeichert sind; und
eine optisch durchlässige Steuereinheit (103, 305), die elektrisch mit der Lichtempfangsvorrichtung (102, 304) und dem Datenspeicherelement (104, 306) verbunden ist, wobei die Steuereinheit (103, 305) konfiguriert ist, mit dem Datenspeicherelement (104, 306) zu kommunizieren, um basierend auf der Anfrage Informationsdaten zu beziehen, die im Datenspeicherelement (104, 306) gespeichert sind;
wobei die Informationsspeichereinheit (101, 201, 302) so angeordnet und konfiguriert ist, dass ein optisches Signal, das von einer Lichtausstrahlungsvorrichtung außerhalb der Informationsspeichereinheit (101, 201, 302) übertragen wird, sich ungeleitet von der äußeren Lichtausstrahlungsvorrichtung zur Lichtempfangsvorrichtung (102, 304) durch die Informationsspeichereinheit ausbreitet.

2. Informationsspeichereinheit (101, 201, 302) nach Anspruch 1, weiter umfassend eine optisch durchlässige Lichtausstrahlungsvorrichtung (106, 303), die zum Ausstrahlen von Licht in einigen Richtungen angeordnet und elektrisch mit der optisch durchlässigen Steuereinheit (103, 305) verbunden ist.

3. Informationsspeichereinheit (101, 201, 302) nach Anspruch 2, wobei die Steuereinheit (103, 305) weiter konfiguriert ist, falls die Informationsdaten, die der Anfrage entsprechen, auf dem Datenspeicherelement (104, 306) gefunden werden, die optisch durchlässige Lichtausstrahlungsvorrichtung (106, 303) zu steuern, ein optisches Signal auszustrahlen, das die angefragten Informationsdaten anzeigt.

4. Informationsspeichereinheit (101, 201, 302) nach Anspruch 1, weiter umfassend elektrisch leitende Pfade, die angeordnet sind, die optisch durchlässige Steuereinheit (103, 305) mit einer äußeren Steuereinheit elektrisch zu verbinden, die bei einem Abstand von der Informationsspeichereinheit (101, 201, 302) angeordnet ist, und konfiguriert sind, ein Signal, das die angefragten Informationsdaten anzeigt, an die äußere Steuereinheit zu übertragen.

5. Informationsspeichereinheit (101, 201, 302) nach Anspruch 1, weiter umfassend elektrisch leitende Pfade, die angeordnet sind, elektrischen Strom an die Informationsspeichereinheit (101, 201, 302) bereitzustellen.

6. Informationsspeichereinheit (101, 201, 302) nach Anspruch 1, weiter umfassend eine Funkfrequenzempfängereinheit, die konfiguriert ist, drahtlos Strom von einem Fernsender zu empfangen und elektrischen Strom an die Informationsspeichereinheit (101, 201, 302) bereitzustellen.

7. Speichervorrichtung (300, 400), umfassend eine Vielzahl von Informationsspeichereinheiten (101, 201, 302) nach einem der Ansprüche 1 bis 6, wobei die Informationsspeichereinheiten (101, 201, 302) so angeordnet sind, dass ein optisches Signal sich ungeleitet von der äußeren Lichtausstrahlungsvorrichtung zu irgendeiner der Informationsspeichereinheiten (101, 201, 302) ausbreitet.

8. Speichervorrichtung (300, 400) nach Anspruch 7, wobei die Vielzahl von Informationsspeichereinheiten (101, 201, 302) so angeordnet ist, dass ein optisches Signal sich ungeleitet von einer ersten Informationsspeichereinheit (101, 201, 302) zu einer zweiten Informationsspeichereinheit (101, 201, 302) durch eine dritte Informationsspeichereinheit (101, 201, 302) ausbreitet.

9. Speichervorrichtung (300, 400) nach Anspruch 7, wobei jede der Informationsspeichereinheiten (101, 201, 302) angrenzend an und in Kontakt mit mindestens einer anderen Informationsspeichereinheit (101, 201, 302) angeordnet ist.

10. Speichervorrichtung (300, 400) nach Anspruch 7, wobei jede der Informationsspeichereinheiten (101, 201, 302) in der Form eines Quaders bereitgestellt und angrenzend an und in Kontakt mit mindestens drei anderen Informationsspeichereinheiten (101, 201, 302) angeordnet ist.

11. Speichersystem (303), umfassend eine Vielzahl von Informationsspeichereinheiten (101, 201, 302) und eine Verarbeitungseinheit (315), wobei jede der Vielzahl von Informationsspeichereinheiten (101, 201, 302) umfasst:
ein optisch durchlässiges Datenspeicherelement (104, 306);
eine optisch durchlässige Lichtempfangsvorrichtung (102, 304), die konfiguriert ist, ein optisches Signal zu empfangen, wobei mindestens ein Teil des optischen Signals aus einigen Richtungen durch ein Material der optisch durchlässigen Lichtempfangsvorrichtung (102, 304) geht, wobei das optische Signal mit dem Speicherelement (104, 306) kommuniziert, und eine Anfrage umfasst, Informationsdaten zu empfangen, die im Datenspeicherelement (104, 306) gespeichert sind; und
eine optisch durchlässige Steuereinheit (103, 305), die elektrisch mit der Lichtempfangsvorrichtung (102, 304) und dem Datenspeicherelement (104, 306) gekoppelt ist, wobei die Steuereinheit (103, 305) konfiguriert ist, mit dem Datenspeicherelement (104, 306) zu kommunizieren, um Informationsdaten, die im Datenspeicherelement (104, 306) gespeichert sind, basierend auf der Anfrage zu beziehen;
wobei jede der Informationsspeichereinheiten (101, 201, 302) so angeordnet und konfiguriert ist, dass sich ein optisches Signal, das von einer Lichtausstrahlungsvorrichtung außerhalb mindestens einer der Vielzahl von Informationsspeichereinheiten (101, 201, 302) übertragen wird, ungeleitet von der äußeren Lichtausstrahlungsvorrichtung zur Lichtempfangsvorrichtung (102, 304) durch eine oder mehrere Informationsspeichereinheiten ausbreitet,
wobei die äußere Lichtausstrahlungsvorrichtung mit der Verarbeitungseinheit verbunden ist.

12. Speichersystem (303) nach Anspruch 11, weiter umfassend eine Lichtempfangsvorrichtung, die mit der Verarbeitungseinheit zum Empfangen optischer Signale von irgendeiner der Informationsspeichereinheiten (101, 201, 302) verbunden ist, die eine optisch durchlässige Lichtausstrahlungsvorrichtung (106, 303) umfasst, die zum Ausstrahlen von Licht in einige Richtungen angeordnet und elektrisch mit der optisch durchlässigen Steuereinheit (103, 305) verbunden ist.

13. Verfahren zum Beziehen von Informationsdaten von einer Speichervorrichtung (300, 400), umfassend:
eine Vielzahl von Informationsspeichereinheiten (101, 201, 302) nach Anspruch 1;
das Verfahren umfassend die Schritte zum:
Empfangen (S1), durch jede der Vielzahl von Informationsspeichereinheiten (101, 201, 302), eines optischen Signals, das eine Anfrage zum Beziehen von Informationsdaten vom Datenspeicherelement (104, 306) umfasst; wobei jede der Informationsspeichereinheiten, die die Anfrage für die Informationsdaten empfängt, gleichzeitig
bestimmt (S2), ob die angefragten Informationsdaten in irgendeiner der Informationsspeichereinheiten (101, 201, 302) liegen; und
falls die angefragten Informationsdaten in einer Informationsspeichereinheit (101, 201, 302) liegen, eine Lichtausstrahlungsvorrichtung (106, 303), die in der Informationsspeichereinheit (101, 201, 302) angeordnet ist, wo die angefragten Informationsdaten liegen, steuert (S3), ein optisches Signal zu übertragen, das Informationen umfasst, die die Informationsdaten anzeigen.

14. Verfahren nach Anspruch 13, wobei, falls die angefragten Informationsdaten in mehr als einer der Vielzahl von Informationsspeichereinheiten (101, 201, 302) liegen, Durchführen gemultiplexter Übertragung von Signalen, die die angefragten Informationsdaten anzeigen, von mehr als einer Informationsspeichereinheit (101, 201, 302).

## Revendications

1. Unité de stockage d'informations (101, 201, 302), comprenant :
un élément de mémoire à transmission optique (104, 306) ;
un dispositif récepteur de lumière à transmission optique (102, 304) configuré pour recevoir un signal optique, au moins une partie dudit signal optique devant passer à travers un matériau dudit dispositif récepteur de lumière à transmission optique (102, 304), depuis plusieurs directions, ledit signal optique communiquant avec l'élément de mémoire (104, 306) et comprenant une demande pour extraire des données d'informations stockées dans ledit élément de mémoire (104, 306) ; et
une unité de commande à transmission optique (103, 305) électriquement raccordée audit dispositif récepteur de lumière (102, 304) et audit élément de mémoire (104, 306), dans laquelle ladite unité de commande (103, 305) est configurée pour communiquer avec l'élément de mémoire (104, 306) pour extraire des données d'informations stockées dans ledit élément de mémoire (104, 306) sur la base de ladite demande ;
dans laquelle ladite unité de stockage d'informations (101, 201, 302) est agencée et configurée de sorte qu'un signal optique transmis depuis un dispositif émetteur de lumière externe à ladite unité de stockage d'informations (101, 201, 302) se propage sans guidage depuis ledit dispositif émetteur de lumière externe vers ledit dispositif récepteur de lumière (102, 304) à travers ladite unité de stockage d'informations.

2. Unité de stockage d'informations (101, 201, 302) selon la revendication 1, comprenant en outre un dispositif émetteur de lumière à transmission optique (106, 303) agencé pour émettre de la lumière dans plusieurs directions et électriquement raccordé à ladite unité de commande à transmission optique (103, 305).

3. Unité de stockage d'informations (101, 201, 302) selon la revendication 2, dans laquelle ladite unité de commande (103, 305) est en outre configurée pour, si lesdites données d'informations correspondant à ladite demande sont trouvées sur ledit élément de mémoire (104, 306), commander ledit dispositif émetteur de lumière à transmission optique (106, 303) pour émettre un signal optique indicatif desdites données d'informations demandées.

4. Unité de stockage d'informations (101, 201, 302) selon la revendication 1, comprenant en outre des trajets électriquement conducteurs agencés pour raccorder électriquement ladite unité de commande à transmission optique (103, 305) à une unité de commande externe agencée à une distance de ladite unité de stockage d'informations (101, 201, 302), et configurée pour transmettre un signal indicatif desdites données d'informations demandées à ladite unité de commande externe.

5. Unité de stockage d'informations (101, 201, 302) selon la revendication 1, comprenant en outre des trajets électriquement conducteurs agencés pour fournir de l'alimentation électrique à ladite unité de stockage d'informations (101, 201, 302).

6. Unité de stockage d'informations (101, 201, 302) selon la revendication 1, comprenant en outre une unité réceptrice de fréquence radio configurée pour recevoir de manière sans fil de l'alimentation d'un émetteur distant et pour fournir de l'alimentation électrique à ladite unité de stockage d'informations (101, 201, 302).

7. Dispositif de stockage (300, 400) comprenant une pluralité d'unités de stockage d'informations (101, 201, 302) selon l'une quelconque des revendications 1 à 6, dans lequel lesdites unités de stockage d'informations (101, 201, 302) sont agencées de sorte qu'un signal optique se propage sans guidage depuis ledit dispositif émetteur de lumière externe vers l'une quelconque desdites unités de stockage d'informations (101, 201, 302).

8. Dispositif de stockage (300, 400) selon la revendication 7, dans lequel ladite pluralité d'unités de stockage d'informations (101, 201, 302) est agencée de sorte qu'un signal optique se propage sans guidage depuis une première unité de stockage d'informations (101, 201, 302) vers une deuxième unité de stockage d'informations (101, 201, 302) à travers une troisième unité de stockage d'informations (101, 201, 302).

9. Dispositif de stockage (300, 400) selon la revendication 7, dans lequel chacune desdites unités de stockage d'informations (101, 201, 302) est agencée de manière adjacente à et en contact avec au moins une autre unité de stockage d'informations (101, 201, 302).

10. Dispositif de stockage (300, 400) selon la revendication 7, dans lequel chacune desdites unités de stockage d'informations (101, 201, 302) est fournie sous la forme d'un cuboïde, et agencée de manière adjacente à et en contact avec au moins trois autres unités de stockage d'informations (101, 201, 302).

11. Système de stockage (303) comprenant une pluralité d'unités de stockage d'informations (101, 201, 302) et une unité de traitement (315), chacune de ladite pluralité d'unités de stockage d'informations (101, 201, 302) comprenant :
un élément de mémoire à transmission optique (104, 306) ;
un dispositif récepteur de lumière à transmission optique (102, 304) configuré pour recevoir un signal optique, au moins une partie dudit signal optique devant passer à travers un matériau dudit dispositif récepteur de lumière à transmission optique (102, 304), depuis plusieurs directions, ledit signal optique communiquant avec l'élément de mémoire (104, 306) et comprenant une demande pour extraire des données d'informations stockées dans ledit élément de mémoire (104, 306) ; et
une unité de commande à transmission optique (103, 305) électriquement raccordée audit dispositif récepteur de lumière (102, 304) et audit élément de mémoire (104, 306), dans laquelle ladite unité de commande (103, 305) est configurée pour communiquer avec l'élément de mémoire (104, 306) pour extraire des données d'informations stockées dans ledit élément de mémoire (104, 306) sur la base de ladite demande ;
dans laquelle chacune desdites unités de stockage d'informations (101, 201, 302) est agencée et configurée de sorte qu'un signal optique transmis depuis un dispositif émetteur de lumière externe à au moins une de ladite pluralité d'unités de stockage d'informations (101, 201, 302) se propage sans guidage depuis ledit dispositif émetteur de lumière externe vers ledit dispositif récepteur de lumière (102, 304) à travers une ou plusieurs unités de stockage d'informations,
dans lequel ledit dispositif émetteur de lumière externe est raccordé à ladite unité de traitement.

12. Système de stockage (303) selon la revendication 11, comprenant en outre un dispositif récepteur de lumière raccordé à ladite unité de traitement pour recevoir des signaux optiques depuis l'une quelconque desdites unités de stockage d'informations (101, 201, 302) comprenant un dispositif émetteur de lumière à transmission optique (106, 303) agencé pour émettre de la lumière dans plusieurs directions et électriquement raccordé à ladite unité de commande à transmission optique (103, 305).

13. Procédé d'extraction de données d'informations depuis un dispositif de stockage (300, 400), comprenant :
une pluralité d'unités de stockage d'informations (101, 201, 302) selon la revendication 1 ;
ledit procédé comprenant les étapes consistant à :
recevoir (S1), par chacune de ladite pluralité d'unités de stockage d'informations (101, 201, 302), un signal optique comprenant une demande pour extraire des données d'informations dudit élément de mémoire (104, 306) ; chacune des unités de stockage d'informations recevant la demande pour les données d'informations simultanément ;
déterminer (S2) si lesdites données d'informations demandées sont situées dans l'une quelconque desdites unités de stockage d'informations (101, 201, 302) ; et
si lesdites données d'informations demandées sont situées dans une unité de stockage d'informations (101, 201, 302), commander (S3) un dispositif émetteur de lumière (106, 303) agencé dans ladite unité de stockage d'informations (101, 201, 302) où lesdites données d'informations demandées sont situées pour transmettre un signal optique comprenant des informations indicatives desdites données d'informations.

14. Procédé selon la revendication 13, dans lequel, si lesdites données d'informations demandées sont situées dans plus d'une de ladite pluralité d'unités de stockage d'informations (101, 201, 302), l'exécution d'une transmission multiplexée de signaux indicatifs desdites données d'informations demandées depuis plus d'une unité de stockage d'informations (101, 201, 302).
